(19) Europäisches Patentamt
European Patent Office
Office européen des brevets

(11) **EP 2 938 175 A1**

(12) **EUROPEAN PATENT APPLICATION**
published in accordance with Art. 153(4) EPC

(43) Date of publication:
**28.10.2015 Bulletin 2015/44**

(51) Int Cl.:
$H05K\ 9/00$ (2006.01)    $H01F\ 1/00$ (2006.01)
$H01F\ 1/22$ (2006.01)

(21) Application number: **13866144.2**

(22) Date of filing: **17.12.2013**

(86) International application number:
**PCT/JP2013/083720**

(87) International publication number:
**WO 2014/098065 (26.06.2014 Gazette 2014/26)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**

(30) Priority: **19.12.2012  JP 2012277352**

(71) Applicant: **TODA KOGYO CORP.**
**Hiroshima 732-0828 (JP)**

(72) Inventor: **YAMAMOTO, Kazumi**
**Otake-shi**
**Hiroshima 739-0652 (JP)**

(74) Representative: **Raynor, Stuart Andrew**
**J A Kemp**
**14 South Square**
**Gray's Inn**
**London WC1R 5JJ (GB)**

(54) **ELECTROMAGNETIC INTERFERENCE SUPPRESSION BODY**

(57)    The present invention relates to an electromagnetic interference suppression sheet comprising a conductive layer comprising a conductive metal filler and having a surface electrical resistance of 100 to 5000 $\Omega$/□, and a magnetic layer comprising a magnetic material mixed therein and having a real part $\mu'$ of a magnetic permeability of 3 to 45 as measured at 100 MHz which is laminated on the conductive layer. The electromagnetic interference suppression sheet of the present invention is suitable for high-density packaging of electronic devices, and has an excellent low-pass filter characteristic in a near electromagnetic field in a wide frequency band ranging from a low frequency to a high frequency.

EP 2 938 175 A1

**Description**

TECHNICAL FIELD

The present invention relates to an electromagnetic interference suppressor for suppressing interference of unnecessary electromagnetic radiation generated from digital electronic devices which includes a conductive layer comprising a conductive filler and a magnetic layer comprising a magnetic filler, both the layers being laminated to each other.

BACKGROUND ART

In recent years, the progress of digital electronic devices has become noticeable. In particular, in mobile electronic devices such as typically cellular phones, digital cameras and clamshell type computers, there is a remarkably increasing demand for higher-frequency actuating signals as well as reduction in size and weight of these devices. Therefore, high-density packaging of electronic parts or wiring circuit boards in these devices is one of the most important technical tasks.

With the recent progress of high-density packaging of electronic parts or wiring circuit boards in electronic devices as well as use of higher-frequency actuating signals therefor, it may be difficult to ensure an adequate distance between the electronic parts that generate noises and the other adjacent parts. For this reason, in order to suppress unnecessary radiation emitted from a microprocessor, LSI or a liquid crystal panel of the electronic devices, electromagnetic interference suppression sheets have been used. In the near electromagnetic filed applications as described above, absorption and reflection phenomena of electromagnetic radiation can be hardly analyzed by a transmission line theory unlike those in the conventionally known far electromagnetic field applications (in which the electromagnetic radiation is in the form of a plane wave) (refer to Osamu HASHIMOTO, "Trend of Wave Absorbers", Journal of the Institute of Electronics, Information and Communication Engineers, Vol. 86, No. 10, pp. 800-803, October, 2003). For this reason, the electromagnetic interference suppression sheets used in the near electromagnetic field applications have been often designed depending upon experiences of experts only. In recent years, as described in Patent Literatures 1 and 2, electromagnetic interference suppression sheets of such a type in which flat magnetic metal particles as soft magnetic particles are blended in a resin, have been used for absorbing electromagnetic radiation in the near electromagnetic magnetic field. The method for evaluating characteristics of an electromagnetic interference (noise) suppression sheet has been standardized by IEC 623333-1 in 2006.

Hitherto, there is described an electromagnetic interference suppressing member which comprises, as soft magnetic particles, flat Fe-Al-Si alloy particles having an average particle diameter of 10 $\mu$m in an amount of 90% by weight (58.9% by volume as calculated under such a condition that a density of the alloy particles is 6.9 kg/L and a density of the resin is 1.1 kg/L with respect to the compositions 1 and 3), and which has a thickness of 1.2 mm (Patent Literature 1).

As the production method, there is described such a method for producing a magnetic sheet in which after a magnetic coating material obtained by dispersing flat magnetic metal particles in a resin and a solvent is applied onto a substrate having a release layer and then dried, the resulting dried coating film is peeled off from the substrate to obtain the magnetic sheet. In Examples of the above production method, there is also described the magnetic shielding sheet having a dried film thickness of 120 $\mu$m in which sendust particles are filled at a maximum filling percentage of 80% by weight (56.0% by volume as calculated under such a condition that a density of the sendust particles is 6.9 kg/L and a density of the resin is 1.1 kg/L). This indicates that the above method can realize production of a thinner magnetic sheet as compared to that described in Patent Literature 1. It is considered that the thus obtained thin magnetic sheet is more suitable for high-density mounting of electronic parts or wiring circuit boards (Patent Literature 2).

Also, there is disclosed a relationship between a surface electrical resistance and noise suppression of a conductive layer (Nobuyuki HIRATSUKA "Soft Magnetic Materials for Noise Suppression and Applications thereof", May, 2008).

Further, there is also known a sheet comprising a conductive layer and a magnetic layer which are laminated to each other (Patent Literatures 3 to 5 and 10).

In addition, there are known an electromagnetic interference suppression sheet produced by dispersing carbonyl iron particles in a resin (Patent Literature 6), and an electromagnetic interference suppression sheet produced by dispersing a conductive carbon and a soft magnetic material in a resin (Patent Literatures 7, 8 and 9).

CITATION LIST

PATENT LITERATURE

Patent Literature 1: Japanese Patent Application Laid-Open (KOKAI) No. 7-212079(1995)
Patent Literature 2: Japanese Patent Application Laid-Open (KOKAI) No. 2000-244171
Patent Literature 3: Japanese Patent Application Laid-Open (KOKAI) No. 10-075088(1998)
Patent Literature 4: Japanese Patent Application Laid-Open (KOKAI) No. 2002-198686
Patent Literature 5: Japanese Patent Application Laid-Open (KOKAI) No. 2010-135701
Patent Literature 6: Japanese Patent Application Laid-Open (KOKAI) No. 2006-196747
Patent Literature 7: Japanese Patent Application Laid-Open (KOKAI) No. 2007-288006
Patent Literature 8: Japanese Patent Application Laid-Open (KOKAI) No. 2007-129179
Patent Literature 9: Japanese Patent Application Laid-Open (KOKAI) No. 2008-244358
Patent Literature 10: Japanese Patent Application Laid-Open (KOKAI) No. 2010-153542

SUMMARY OF INVENTION

TECHNICAL PROBLEM

With the progress of reduction in size and weight of digital electronic devices, it has been strongly required to realize higher-density packaging of electronic parts and wiring circuit boards and provide an electromagnetic interference suppression sheet that has a smaller thickness and can exhibit a more excellent electromagnetic absorption performance and a less electromagnetic reflection in a near electromagnetic field. In general, as the thickness of an electromagnetic interference suppression sheet is reduced, an electromagnetic absorption performance thereof is deteriorated. Therefore, in order to further reduce a thickness of the electromagnetic interference suppression sheet, it is required to increase a content of magnetic particles in the sheet and attain a high magnetic loss therein, and ensure practical flexibility and strength of the sheet. However, in order to increase a magnetic permeability of metal magnetic particles and a content thereof in the sheet, not only the use of a high processing technology but also high-level design of the particles such as design of a shape of the magnetic material and design of a particle size distribution thereof as well as processing of the particles are required, and therefore the problem of high costs tends to occur.
In the methods described in Patent Literatures 3 to 5, the conductive layer has merely a function of a reflection layer against electromagnetic radiation and exhibits a large reflection loss in a distributed constant circuit, and therefore there tends to occur attenuation of a high-frequency transmission signal therein.
Also, in the method described in Patent Literature 6, attenuation of transmission signals in GHz bands tends to be hardly caused to a sufficient extent.
In addition, in the methods described in Patent Literatures 7, 8, 9 and 10, when increasing an amount of the conductive filler filled in the conductive layer, an electrical resistance thereof tends to be lowered, so that transmission characteristics in a low frequency region, i.e., a transmission signal region, tends to be deteriorated. Further, in Patent Literature 9, since a large loss tends to occur at a frequency of not less than 800 MHz, the use of the suppression sheet is limited to the applications using a transmission signal having a frequency region of not more than 800 MHz.
Further, the method described in Patent Literature 10 in which the coating material is applied onto the substrate, there tends to arise such a problem that the resulting sheet tends to be insufficient in flexibility and adhesion follow-up property.
In consequence, an object of the present invention is to provide an electromagnetic interference suppressor capable of exhibiting an excellent low-pass filter characteristic in a near electromagnetic field (good balance between a transmission loss and a reflection coefficient thereof, more specifically, a transmission loss of not more than 3 dB and a reflection coefficient of not more than -9 dB as measured at 500 MHz using a microstripline, and a transmission loss of not less than 10 dB and a reflection coefficient of not more than -9 dB as measured at 3 GHz using a microstripline).

SOLUTION TO PROBLEM

The above object can be achieved by the following aspects of the present invention.
That is, according to the present invention, there is provided an electromagnetic interference suppressor comprising:

a conductive layer which comprises a conductive filler comprising at least one metal selected from the group consisting of gold, silver, copper and nickel, and which has a surface electrical resistance of 100 to 5000 $\Omega/\square$; and

a magnetic layer comprising soft magnetic particles and a resin which is laminated on the conductive layer (Invention 1)

Also, according to the present invention, there is provided the electromagnetic interference suppressor as described in the above Invention 1, wherein the conductive layer comprises a resin and the conductive filler comprising at least one metal selected from the group consisting of gold, silver, copper and nickel (Invention 2).

Also, according to the present invention, there is provided the electromagnetic interference suppressor as described in the above Invention 1 or 2, wherein a real part of a complex relative magnetic permeability of the magnetic layer as measured at 100 MHz is 3 to 45 (Invention 3).

Also, according to the present invention, there is provided the electromagnetic interference suppressor as described in any one of the above Inventions 1 to 3, wherein a content of the conductive filler in the conductive layer is 15 to 40% by volume (Invention 4).

Also, according to the present invention, there is provided the electromagnetic interference suppressor as described in any one of the above Inventions 1 to 4, wherein the soft magnetic particles are formed of at least one material selected from the group consisting of carbonyl iron, magnetite, spinel ferrite and Sendust (Invention 5).

Also, according to the present invention, there is provided the electromagnetic interference suppressor as described in any one of the above Inventions 1 to 5, wherein the conductive layer has a thickness of 10 to 50 $\mu$m, and the magnetic layer has a thickness of 50 to 200 $\mu$m (Invention 6).

Also, according to the present invention, there is provided the electromagnetic interference suppressor as described in any one of the above Inventions 1 to 6, wherein when subjecting the electromagnetic interference suppressor having a thickness of not more than 100 $\mu$m to measurement using a microstripline, a transmission loss and a reflection coefficient thereof are not more than 3 dB and not more than -9 dB, respectively, as measured at 500 MHz, and not less than 10 dB and not more than -9 dB, respectively, as measured at 3 GHz (Invention 7).

ADVANTAGEOUS EFFECTS OF INVENTION

In accordance with the present invention, it is possible to obtain an electromagnetic interference suppressor capable of exhibiting an excellent low-pass filter characteristic in a near electromagnetic field.

DESCRIPTION OF EMBODIMENTS

First, the electromagnetic interference suppressor according to the present invention is described.

The electromagnetic interference suppressor according to the present invention comprises a conductive layer comprising a conductive filler comprising at least one metal selected from the group consisting of gold, silver, copper and nickel, and a magnetic layer comprising soft magnetic particles and a resin which is laminated on the conductive layer.

The conductive layer used in the present invention is described below.

As the conductive metal filler to be incorporated in the conductive layer used in the present invention, there may be used at least one metal selected from the group consisting of gold, silver, copper and nickel. The conductive metal filler suitably has a particle diameter of 0.1 to 20 $\mu$m and a BET specific surface area of 0.2 to 20 m$^2$/g. The particle shape of the conductive metal filler is not particularly limited.

The conductive layer used in the present invention may be formed of the metal filler, or may be formed by compounding the conductive metal filler in a resin.

In the case where the conductive layer used in the present invention is formed by compounding the conductive metal filler in a resin, the amount of the conductive metal filler compounded is preferably 15 to 40% by volume and more preferably 20 to 35% by volume. When the amount of the conductive filler compounded is less than the above-specified range, the transmission loss S21 tends to be lowered. On the other hand, when the amount of the conductive metal filler compounded is as large as more than the above-specified range, the surface electrical resistance of the conductive layer tends to be less than 100 $\Omega/\square$, so that the transmission loss of the resulting sheet as measured at 500 MHz tends to be increased, and therefore the low-pass characteristic thereof tends to be deteriorated. Further, the resulting sheet also tends to be deteriorated in strength and flexibility. Meanwhile, a "good flexibility" of the sheet as used in the present invention means that the sheet can be folded and bent 180° and further can restore into its original state.

The conductive layer used in the present invention preferably comprises a resin in an amount of 25 to 80% by volume. When the content of the resin in the conductive layer is less than 25% by volume, the resulting sheet tends to be deteriorated in flexibility. When the content of the resin in the conductive layer is more than 80% by volume, the surface electrical resistance of the conductive layer tends to be increased. The content of the resin in the conductive layer is more preferably 26 to 60% by volume and still more preferably 28 to 40% by volume.

Examples of the resin used in the conductive layer include a styrene-based elastomer, an olefin-based elastomer, a polyester-based elastomer, a polyamide-based elastomer, a urethane-based elastomer and a silicone-based elastomer. Specific examples of the styrene-based elastomer include SEBS (styrene-ethylene-butylene-styrene block copolymer) and the like. As the resin, there may also be used an acrylic resin, an epoxy resin, a phenol resin and a polyolefin resin. In addition, the above elastomer may be mixed with the acrylic resin, epoxy resin, phenol resin and polyolefin resin, etc., and the obtained resin mixture may be used as the resin.

The conductive layer used in the present invention preferably comprises respective flame retardants in an amount of 5 to 20% by volume. When the amount of the respective flame retardants compounded in the conductive layer is less than 5% by volume, the flame-retarding effect tends to be insufficient. When the amount of the respective flame retardants compounded in the conductive layer is more than 20% by volume, the resulting sheet tends to be deteriorated in electromagnetic wave absorption. Preferred examples of the flame retardants include melamine polyphosphate, magnesium hydroxide and hydrotalcite. Among these flame retardants, more preferred are magnesium hydroxide and melamine polyphosphate. The total amount of the flame retardants compounded in the conductive layer is preferably 5 to 40% by volume.

The conductive layer used in the present invention preferably comprises an antioxidant in an amount of 0.5 to 3% by volume. When the amount of the antioxidant compounded in the conductive layer is less than 0.5% by volume, an oxidation resistance of the conductive layer tends to be undesirably lowered. When the amount of the antioxidant compounded in the conductive layer is more than 3% by volume, the resulting sheet tends to be deteriorated in electromagnetic wave absorption. Preferred examples of the antioxidant include 2',3-bis[[3-[3,5-di-tert-butyl-4-hydroxyphenyl]propionyl]] propionohydrazide ("IRGANOX MD1024" produced by Ciba Specialty Chemicals Corp.) and the like. The antioxidant for resins may be appropriately selected from tetrakis[methylene-3-(3',5'-di-tert-butyl-4'-hydroxyphenyl)propionate], tris-(3,5-di-t-butyl-4-hydroxybenzyl)-isocyanurate and N,N'-hexamethylenebis(3,5-di-t-butyl-4-hydroxyhydrocinnamide) depending upon the kind of resin used. As the antioxidant for rubber-based resins, there may be suitably used CTPI N-cyclohexylthiophthalimide produced by Toray Industries Inc.

Meanwhile, the conductive layer used in the present invention may comprise magnetic particles such as magnetite, carbonyl iron and ferrite to control a high-frequency impedance of the conductive layer. The amount of these compounds are usually 0 to 20 vol%.

In addition, in the conductive layer used in the present invention, the above conductive materials may be used in combination with a conductive carbon such as conductive carbon black, fibrous carbon obtained by processing carbon fibers, and carbon nanotube.

Next, the magnetic layer used in the present invention is described below.

The soft magnetic particles compounded in the magnetic layer used in the present invention is formed of at least one kind of particles selected from the group consisting of carbonyl iron, magnetite, spinel ferrite, Sendust, silicon steel, iron and the like. The shape of the soft magnetic particles may be any of a granular shape, a spherical shape, a fragment shape, an acicular shape and a flat shape.

The maximum particle diameter of the soft magnetic particles compounded in the magnetic layer used in the present invention is preferably not more than 1/3 time a thickness of the sheet and more preferably not more than 1/5 time a thickness of the sheet. When the maximum particle diameter of the soft magnetic particles in the magnetic layer is more than 1/3 time a thickness of the sheet, the resulting electromagnetic interference suppression sheet tends to have a poor surface smoothness, and therefore tends to be deteriorated not only in adhesion to an electromagnetic radiation source but also in electromagnetic wave absorption performance.

Also, the soft magnetic particles used in the present invention preferably have a true density of 4.0 to 9.0 g/cm$^3$ and more preferably 5.0 to 8.0 g/cm$^3$.

The soft magnetic particles used in the present invention may be subjected to surface treatments with a coupling agent such as a titanate-based coupling agent or a silane-based coupling agent, if required, though the present invention is not particularly limited thereto. The metal-based soft magnetic particles are preferably surface-treated with a phosphoric acid-based coupling agent. The amount of the coupling agent used for surface-treating the soft magnetic particles is 0.1 to 1.0% by weight based on the weight of the soft magnetic particles. When the amount of the coupling agent treated is less than 0.1% by weight, the soft magnetic particles tends to hardly exhibit a sufficient affinity to the resin, so that the resulting magnetic layer tends to fail to maintain a sufficient oxidation stability. When the amount of the coupling agent treated is more than 1.0% by weight, the resulting sheet tends to exhibit an excessively high impedance and therefore tends to be deteriorated in electromagnetic wave absorption. The amount of the coupling agent used for surface-treating the soft magnetic particles is preferably 0.1 to 0.5% by weight.

Examples of the titanate-based coupling agent include isopropyl tris(stearoyl)titanate, isopropyl tris(dioctyl pyrophosphate)titanate, isopropyl tri(N-aminoethyl/aminoethyl)titanate, tetraoctyl bis(ditridecyl phosphate)titanate, tetra(2-2-diallyloxymethyl-1-butyl) bis(ditridecyl)phosphate titanate, bis(dioctyl pyrophosphate)oxyacetate titanate and bis(dioctyl pyrophosphate)ethylene titanate.

Examples of the silane-based coupling agent include those suitable as a coupling agent for elastomers. Specific examples of the silane-based coupling agent include vinyl trichlorosilane, vinyl trimethoxysilane, vinyl triethoxysilane, 2-(3,4-epoxycyclohexyl)ethyl trimethoxysilane, 3-glycidoxypropyl trimethoxysilane, 3-glycidoxypropylmethyl diethoxysilane, 3-glycidoxypropyl triethoxysilane, 3-methacryloxypropylmethyl dimethoxysilane, 3-methacryloxypropyl trimethoxysilane, 3-methacryloxypropylmethyl diethoxysilane, 3-methacryloxypropyl triethoxysilane, 3-acryloxypropyl trimethoxysilane, N-2(aminoethyl) 3-aminopropylmethyl dimethoxysilane, N-2(aminoethyl) 3-aminopropyl trimethoxysilane, N-2(aminoethyl) 3-aminopropyl triethoxysilane, 3-aminopropyl trimethoxysilane, 3-aminopropyl triethoxysilane, 3-mercaptopropylmethyl dimethoxysilane, 3-mercaptopropyl trimethoxysilane and bis(triethoxysilylpropyl)tetrasulfide.

In addition, the metal-based soft magnetic particles may be surface-treated with a phosphoric acid-based compound. The amount of the phosphoric acid-based compound used for surface-treating the soft magnetic particles is 0.1 to 0.5% by weight in terms of phosphoric acid based on the weight of the soft magnetic particles. Further, the soft magnetic particles may be suface-treated with 0.1 to 1.0% by weight of the silane coupling agent. When the amount of phosphoric acid surface-treated is less than 0.1% by weight, the soft magnetic particles tend to be deteriorated in oxidation stability. When the amount of phosphoric acid surface-treated is more than 0.5% by weight, the resulting sheet tends to have a low magnetic permeability and therefore tends to be deteriorated in electromagnetic interference suppression effect. The amount of the phosphoric acid-based compound used for surface-treating the soft magnetic particles is preferably 0.1 to 0.4% by weight.

The magnetic layer comprises the soft magnetic particles and a resin, and may further comprise the above flame retardant and antioxidant, etc.

The magnetic layer preferably comprises a resin in an amount of 24 to 65% by volume. When the content of the resin in the magnetic layer is less than 24% by volume, the resulting sheet tends to be brittle. When the content of the resin in the magnetic layer is more than 65% by volume, the resulting sheet tends to have a low magnetic permeability. The content of the resin in the magnetic layer is more preferably 26 to 45% by volume, and still more preferably 30 to 40% by volume.

The magnetic layer preferably comprises the soft magnetic particles in an amount of 35 to 65% by volume and more preferably 38 to 60% by volume.

The magnetic layer used in the present invention preferably comprises the flame retardants as used in the conductive layer in an amount of 5 to 20% by volume.

The magnetic layer used in the present invention preferably comprises the antioxidant as is usable in the conductive layer in an amount of 0.5 to 3% by volume.

The resin constituting the magnetic layer may also be selected from the same resins as used in the conductive layer. The resin used in the magnetic layer may be the same as or different from the resin used in the conductive layer, and the resin used in the magnetic layer is preferably the same as the resin used in the conductive layer.

In the present invention, a real part of a complex relative magnetic permeability of the magnetic layer as measured at 100 MHz is preferably 3 to 45. When the real part of a complex relative magnetic permeability of the magnetic layer as measured at 100 MHz is less than 3, the reflection loss of the resulting sheet tends to be increased, so that the transmission signal tends to be attenuated. When the real part of a complex relative magnetic permeability of the magnetic layer as measured at 100 MHz is more than 45, the impedance of the circuit tends to become large, so that the reflection loss of the resulting sheet tends to be increased. The real part of a complex relative magnetic permeability of the magnetic layer as measured at 100 MHz is more preferably 4 to 44 and still more preferably 8 to 42.

The electromagnetic interference suppressor according to the present invention is preferably in the form of a sheet having a thickness of not more than 200 $\mu$m. When the thickness of the electromagnetic interference suppressor is more than 200 $\mu$m, the electromagnetic interference suppressor tends to be too thick to be adapted for high-density packaging of electronic circuits. The thickness of the electromagnetic interference suppressor is more preferably not more than 150 $\mu$m, still more preferably 20 to 120 $\mu$m and further still more preferably 25 to 50 $\mu$m.

In the electromagnetic interference suppressor according to the present invention, the ratio between thicknesses of the conductive layer and the magnetic layer is not particularly limited, and assuming that the thickness of the conductive layer is 1, the ratio of the thickness of the conductive layer to the thickness of the magnetic layer is preferably 1:1 to 1:10 and more preferably 1:1 to 1:5.

In the electromagnetic interference suppressor according to the present invention, the thickness of the conductive layer is preferably 10 to 50 $\mu$m, and more preferably 12 to 45 $\mu$m, and the thickness of the magnetic layer is preferably 50 to 200 $\mu$m, and more preferably 60 to 150 $\mu$m.

In the electromagnetic interference suppressor according to the present invention, the order of lamination of the conductive layer and the magnetic layer is not particularly limited. However, it is preferred that the magnetic layer is disposed on a surface of the resulting laminate which is near to signals transmitted.

The electromagnetic interference suppressor according to the present invention has such a suitable low-pass filter characteristic that when measured using a microstripline mounted to an electromagnetic interference suppression sheet having a lamination thickness of 100 $\mu$m, a transmission loss thereof is not more than 3 dB as measured at 500 MHz and not less than 10 dB as measured at 3 GHz. Also, in the electromagnetic interference suppressor according to the present invention, the magnetic layer can be processed more easily than those of a conventional magnetic single layer type. When the transmission loss as measured at 500 MHz is more than 3 dB, the transmission loss in the signal band tends to be increased, so that the actuating signal tends to be reduced. On the other hand, when the transmission loss as measured at 3 GHz is less than 10 dB, suppression of the n-order harmonic noise of the actuating signal tends to be insufficient. When subjecting the electromagnetic interference suppressor according to the present invention to the measurement using a microstripline, it is more preferred that the transmission loss and reflection coefficient thereof are not more than 2.5 dB and not more than -9 dB, respectively, as measured at 500 MHz, and not less than 10 dB and not more than -9 dB, respectively, as measured at 3 GHz.

Next, the process for producing the electromagnetic interference suppressor according to the present invention is described.

The electromagnetic interference suppressor according to the present invention may be suitably produced by applying a coating material in which the above conductive filler and/or the above soft magnetic particles are dispersed, onto a substrate, adjusting a thickness of the resulting coating layer after dried, and laminating the resulting conductive layer and magnetic layer on each other, followed by thermally compressing the thus formed laminated layers together. Alternatively, the electromagnetic interference suppressor may also be produced by laminating the separately formed conductive layer and magnetic layer and then thermally compressing the resulting laminate. The method of using the coating material for the respective layers is preferred because the respective fillers can be filled therein with a high density and can be uniformly dispersed therein. In addition, a conductive coating material comprising a predetermined metal filler may be applied onto a magnetic layer previously prepared, to thereby obtain the aimed electromagnetic interference suppressor.

The electromagnetic interference suppressor according to the present invention can be used for a flat cable for high-frequency signals, a connector for cables and a flexible printed circuit board. By using the electromagnetic interference suppressor according to the present invention, it can be expected to ensure high-density packaging of electronic parts, decrease a size of a substrate and reduce noise-emitting sources of a wiring circuit board itself. With the above construction, higher-density packaging of electronic circuits can be achieved, thereby enabling reduction in driving voltage and increase in electric current flowing therethrough, and mounting a high-density circuit having a high noise resistance on a substrate.

## EXAMPLES

The methods for measuring various properties as described in the following Examples, etc., are as follows.

True density of particles:

The true density of the particles was measured by the following method. That is, using a density meter "MULTIVOLUME DENSIMETER 1305 Model" manufactured by Micro-Melitecs Co., Ltd., 28 g (W) of the particles were charged in a metering cell thereof, and a helium gas pressure-based sample volume (V) of the particles was measured. The true density of the particles was calculated from the following formula:

$$\text{True density} = W/V \ (g/cm^3).$$

[Measurement of low-pass filter characteristic (transmission loss S21)]

A microstripline having a length of 75 mm, a width of 2.3 mm and a thickness of 35 $\mu$m as well as an impedance controlled to 50 $\Omega$ was mounted on a substrate and used for measurement of the low-pass filter characteristic. A sheet separately prepared was cut to produce a test specimen having a width of 40 mm and a length of 50 mm.

The microstripline was connected to a network analyzer "N5230A" manufactured by Agilent Technologies Corp., to measure an S parameter of the microstripline. More specifically, the sheet as the test specimen was mounted to the microstripline such that the length direction of the microstripline was aligned with the length direction of the sheet. A 10 mm-thick foamed polystyrene plate having the same size as that of the sheet and an expansion ratio of 20 to 30 times was overlapped on the sheet, and further a load of 300 g was placed on the polystyrene plate to measure a transmission loss as an S parameter S21 (dB) and a reflection coefficient S11 over a frequency range of 10 MHz to 3 GHz.

[Measurement of surface electrical resistance]

The surface electrical resistance of the conductive layer was measured by the method prescribed in JIS K 7194. The sheet having a thickness of not more than 100 $\mu$m was cut into 50 mm in square to measure a thickness thereof. Four pin probes "LSP" of a resistivity meter "Loresta-GP" manufactured by Mitsubishi Chemical Corp., were pressed onto a central portion of the sheet to measure a surface electrical resistance thereof.

[Preparation of molded body]

A molded body for measurement of a magnetic permeability was prepared as follows. That is, a magnetic layer was cut by a ring-shaped die having an outer diameter of 7 mm and an inner diameter of 3 mm to obtain 20 ring-shaped sheets. The thus obtained ring-shaped sheets were overlapped with each other in a die and compression-molded therein under a pressure of 0.1 MPa at a die temperature of 85°C for 1 min to prepare a cylindrical doughnut-shaped molded body for measurement of a magnetic permeability having an outer diameter of 7 mm, an inner diameter of 3 mm and a thickness of 1.4 mm (molded body for a coaxial tube test).

[Measurement of complex magnetic permeability]

Using a material constant measurement device, the thus obtained molded body was subjected to measurement of a complex magnetic permeability thereof at a frequency of 100 MHz by a network analyzer to determine a real part $\mu$' of the complex magnetic permeability.

[Example 1]

Granular magnetite ("MAT305" produced by Toda Kogyo Corp.; density: 5.0 g/cm$^3$), a styrene-based elastomer, conductive metal particles (gold particles; "AUP500" produced by Osaki Industry Co., Ltd.; density: 19.3 g/cm$^3$), melamine polyphosphate ("MPP-A" produced by Sanwa Chemical Co., Ltd.; density: 1.8 g/cm$^3$) as a flame retardant and magnesium hydroxide ("KISMA 5A" produced by Kyowa Chemical Co., Ltd.; density: 2.4 g/cm$^3$) as a flame retardant were weighed in amounts of 40% by volume, 28% by volume, 30% by volume, 15% by volume and 20% by volume, respectively, in terms of a volume percentage after removal of a solvent from the resulting mixture, and added and mixed in a solution prepared by dissolving 20% by weight of the styrene-based elastomer (density: 0.9 g/cm$^3$) in cyclohexanone ("TF-4200E" produced by Hitachi Kasei Kogyo Co., Ltd.). The resulting mixture was stirred using a "Power Homogenizer" manufactured by SMT Corp., at a rotating speed of 15000 rpm for 60 min, thereby obtaining a slurry. At that time, ethyl cyclohexanone having the same volume as that of the elastomer solution was added to the slurry to control a viscosity of the slurry. The resulting slurry was subjected to vacuum defoaming treatment, and then applied onto a carrier film using a doctor blade, followed by drying the applied slurry to remove the solvent therefrom, thereby obtaining a sheet having a thickness of 30 $\mu$m. The thus obtained sheet was molded at a temperature of 120°C under a pressure of 60 MPa for a pressing time of 2 min, and the carrier film was released from the resulting molded sheet, thereby obtaining a conductive layer having a thickness of 20 $\mu$m. The resulting sheet had a surface electrical resistance of 460 $\Omega/\square$. Also, it was confirmed that the obtained sheet had a smooth surface and an excellent flexural property. The total content of the fillers in the conductive layer (total content of the conductive metal filler and flame retardant) was 65% by volume.

In the same manner as in the above procedure for production of the conductive layer, the styrene-based elastomer, Sendust-flattened magnetic particles having an average particle diameter of 50 $\mu$m (density: 6.9 g/cm$^3$), melamine polyphosphate ("MPP-A" produced by Sanwa Chemical Co., Ltd.; density: 1.8 g/cm$^3$) as a flame retardant and magnesium hydroxide ("KISMA 5A" produced by Kyowa Chemical Co., Ltd.; density: 2.4 g/cm$^3$) as a flame retardant were weighed in amounts of 40% by volume, 44% by volume, 8% by volume and 8% by volume, respectively, in terms of a volume percentage after removal of a solvent from the resulting mixture, and added and mixed in a solution prepared by dissolving 20% by weight of the styrene-based elastomer (density: 0.9 g/cm$^3$) in cyclohexanone ("TF-4200E" produced by Hitachi Kasei Kogyo Co., Ltd.). The resulting mixture was stirred using a "Power Homogenizer" manufactured by SMT Corp., at a rotating speed of 15000 rpm for 60 min, thereby obtaining a slurry. The resulting slurry was subjected to vacuum defoaming treatment, and then applied onto a carrier film using a doctor blade, followed by drying the applied slurry to remove the solvent therefrom, thereby obtaining a sheet having a thickness of 90 $\mu$m. The thus obtained sheet was molded at a temperature of 120°C under a pressure of 60 MPa for a pressing time of 2 min, thereby obtaining a magnetic layer having a thickness of 70 $\mu$m. The resulting magnetic layer had a magnetic permeability $\mu$' of 43 as measured at 100 MHz.

The conductive layer and the magnetic layer prepared above were overlapped on each other to obtain a laminated sheet having a total thickness of 90 $\mu$m. The thus obtained sheet was subjected to measurement of an S parameter using a microstripline having a length of 75 mm, a width of 2.3 mm, a thickness of 35 $\mu$m and an impedance of 50 $\Omega$ by a network analyzer. As a result of the measurement, the resulting sheet exhibited such an excellent low-pass filter characteristic that a transmission loss S21 and a reflection coefficient thereof were 2.4 dB and -10.5 dB, respectively, as measured at 500 MHz, and 13 dB and -14 dB, respectively, as measured at 3 GHz.

Meanwhile, a sheet produced by laminating a 50 $\mu$m-thick conductive layer obtained after applying and then drying a coating material therefor and a 70 $\mu$m-thick magnetic layer obtained after applying and then drying a coating material therefor and compression-molding the resulting laminate at 120°C under a pressure of 60 MPa for 2 min exhibited the substantially same thickness and low-pass filter characteristic as those of the above sheet.

[Example 2]

A conductive layer having a thickness of 20 $\mu$m after subjected to thermal compression-molding was produced in the same manner as in Example 1 except that the formulation therefor was changed such that conductive metal particles (silver particles; "AG2500SS" produced by Osaki Industry Co., Ltd.; density: 10.5 g/cm$^3$), conductive metal particles (silver coated copper particles; "CE-1110" produced by Fukuda Metal Foil & Powder Co., Ltd.; density: 8.9 g/cm$^3$), melamine polyphosphate ("MPP-A" produced by Sanwa Chemical Co., Ltd.; density: 1.8 g/cm$^3$) as a flame retardant and magnesium hydroxide ("KISMA 5A" produced by Kyowa Chemical Co., Ltd.; density: 2.4 g/cm$^3$) as a flame retardant were used in amounts of 20% by volume, 13% by volume, 15% by volume and 15% by volume, respectively. The thus obtained sheet had a surface electrical resistance of 230 $\Omega/\square$.

A magnetic layer having a thickness of 80 $\mu$m after subjected to compression-molding was produced in the same manner as in Example 1 except that Sendust-flattened magnetic particles having an average particle diameter of 50 $\mu$m (density: 6.9 g/cm$^3$) were used in an amount of 40% by volume, and the amount of the resin used was changed. The thus obtained sheet had a magnetic permeability $\mu'$ of 40 as measured at 100 MHz.

The conductive layer and the magnetic layer prepared above were laminated to each other in the same manner as in Example 1, thereby obtaining a laminated sheet having a total thickness of 100 $\mu$m. The obtained laminated sheet was subjected to measurement using a microstripline. As a result of the measurement, it was confirmed that a transmission loss S21 and a reflection coefficient of the sheet was 2.2 dB and -9.8 dB, respectively, as measured at 500 MHz, and 18 dB and -12.5 dB, respectively, as measured at 3 GHz, and therefore the sheet had an excellent low-pass filter characteristic.

[Example 3]

A conductive layer having a thickness of 30 $\mu$m after subjected to compression-molding was produced in the same manner as in Example 1 except that the formulation therefor was changed such that conductive metal particles (nickel; "NF40" produced by Toho Titanium Co., Ltd.; density: 7.8 g/cm$^3$), melamine polyphosphate ("MPP-A" produced by Sanwa Chemical Co., Ltd.; density: 1.8 g/cm$^3$) as a flame retardant and magnesium hydroxide ("KISMA 5A" produced by Kyowa Chemical Co., Ltd.; density: 2.4) as a flame retardant were used in amounts of 25% by volume, 20% by volume and 20% by volume, respectively. The thus obtained conductive layer had a surface electrical resistance of 4600 $\Omega/\square$.

A magnetic layer having a thickness of 70 $\mu$m after subjected to thermal compression-molding was produced in the same manner as in Example 1 except that carbonyl iron ("R1470" produced by International Specialty Products Inc.; density: 7.8) was used in an amount of 60% by volume, and the amount of the resin used was changed. The thus obtained magnetic layer had a magnetic permeability $\mu'$ of 7 as measured at 100 MHz.

The conductive layer and the magnetic layer prepared above were laminated to each other in the same manner as in Example 1, thereby obtaining a laminated sheet having a total thickness of 100 $\mu$m. The obtained laminated sheet was subjected to measurement using a microstripline. As a result of the measurement, it was confirmed that a transmission loss S21 and a reflection coefficient of the sheet were 1.7 dB and -12.6 dB, respectively, as measured at 500 MHz, and 10.5 dB and -16.5 dB, respectively, as measured at 3 GHz, and therefore the sheet had an excellent low-pass filter characteristic.

[Example 4]

A conductive layer having a thickness of 20 $\mu$m after subjected to compression-molding was produced in the same manner as in Example 1 except that the formulation therefor was changed such that conductive metal particles (silver coated copper particles; "CE-1110" produced by Fukuda Metal Foil & Powder Co., Ltd.; density: 8.9 g/cm$^3$), conductive metal particles (nickel; "NF40" produced by Toho Titanium Co., Ltd.; density: 7.8 g/cm$^3$), melamine polyphosphate ("MPP-A" produced by Sanwa Chemical Co., Ltd.; density: 1.8 g/cm$^3$) as a flame retardant and magnesium hydroxide ("KISMA 5A" produced by Kyowa Chemical Co., Ltd.; density: 2.4) as a flame retardant were used in amounts of 5% by volume, 25% by volume, 16% by volume and 15% by volume, respectively. The thus obtained conductive layer had a surface electrical resistance of 600 $\Omega/\square$.

A magnetic layer having a thickness of 80 $\mu$m after subjected to compression-molding was produced in the same manner as in Example 1 except that Sendust-flattened magnetic particles having an average particle diameter of 50 $\mu$m (density: 6.9) were used in an amount of 38% by volume, and the amount of the resin used was changed. The thus obtained sheet had a magnetic permeability $\mu$' of 25 as measured at 100 MHz.

The conductive layer and the magnetic layer prepared above were laminated to each other in the same manner as in Example 1, thereby obtaining a laminated sheet having a total thickness of 100 $\mu$m. The obtained laminated sheet was subjected to measurement using a microstripline. As a result of the measurement, it was confirmed that a transmission loss S21 and a reflection coefficient of the sheet were 2.5 dB and -11.2 dB, respectively, as measured at 500 MHz, and 11 dB and -14.5 dB, respectively, as measured at 3 GHz, and therefore the sheet had an excellent low-pass filter characteristic.

[Example 5]

A conductive layer having a thickness of 30 $\mu$m after subjected to thermal compression-molding was produced in the same manner as in Example 1 except that the formulation therefor in the sheet was changed such that conductive metal particles (silver particles; "AG2500SS" produced by Osaki Industry Co., Ltd.; density: 10.5 g/cm$^3$), conductive metal particles (silver coated copper particles; "CE-1110" produced by Fukuda Metal Foil & Powder Co., Ltd.; density: 8.9 g/cm$^3$), melamine polyphosphate ("MPP-A" produced by Sanwa Chemical Co., Ltd.; density: 1.8 g/cm$^3$) as a flame retardant and magnesium hydroxide ("KISMA 5A" produced by Kyowa Chemical Co., Ltd.; density: 2.4) as a flame retardant were used in amounts of 10% by volume, 25% by volume, 20% by volume and 20% by volume, respectively. The thus obtained conductive layer had a surface electrical resistance of 140 $\Omega/\square$.

A magnetic layer having a thickness of 70 $\mu$m after subjected to compression-molding was produced in the same manner as in Example 1 except that soft ferrite particles ("BSN-714" produced by Toda Kogyo Corp.; density: 5.1) were used in an amount of 60% by volume, and the amount of the resin used was changed.

The conductive layer and the magnetic layer prepared above were laminated to each other in the same manner as in Example 1, thereby obtaining a laminated sheet having a total thickness of 100 $\mu$m. The thus obtained sheet had a magnetic permeability $\mu$' of 4 as measured at 100 MHz. The resulting laminated sheet was subjected to measurement using a microstripline. As a result of the measurement, it was confirmed that a transmission loss S21 and a reflection coefficient of the sheet were 2.7 dB and -9.9 dB, respectively, as measured at 500 MHz, and 13 dB and -12.8 dB, respectively, as measured at 3 GHz, and therefore the sheet had an excellent low-pass filter characteristic.

[Example 6]

A conductive layer having a thickness of 25 $\mu$m after subjected to thermal compression-molding was produced in the same manner as in Example 1 except that the formulation therefor in the sheet was changed such that the resin was replaced with the resin 2 (phenol-based thermosetting resin "115B" produced by Tomoegawa Co., Ltd.), and conductive metal particles (nickel; "NF40" produced by Toho Titanium Co., Ltd.; density: 7.8 g/cm$^3$), melamine polyphosphate ("MPP-A" produced by Sanwa Chemical Co., Ltd.; density: 1.8 g/cm$^3$) as a flame retardant and magnesium hydroxide ("KISMA 5A" produced by Kyowa Chemical Co., Ltd.; density: 2.4 g/cm$^3$) as a flame retardant were used in amounts of 40% by volume, 10% by volume and 20% by volume, respectively. The thus obtained conductive layer had a surface electrical resistance of 108 $\Omega/\square$.

A magnetic layer having a thickness of 75 $\mu$m after subjected to compression-molding was produced in the same manner as in Example 4 except that the resin was replaced with the resin 2 (phenol-based thermosetting resin "115B" produced by Tomoegawa Co., Ltd.).

The conductive layer and the magnetic layer prepared above were laminated to each other in the same manner as in Example 1, thereby obtaining a laminated sheet having a total thickness of 100 $\mu$m. The thus obtained sheet had a magnetic permeability $\mu$' of 25 as measured at 100 MHz. The resulting laminated sheet was subjected to measurement using a microstripline. As a result of the measurement, it was confirmed that a transmission loss S21 and a reflection coefficient of the sheet were 2.9 dB and -9.2 dB, respectively, as measured at 500 MHz, and 18 dB and -11.3 dB, respectively, as measured at 3 GHz, and therefore the sheet had an excellent low-pass filter characteristic.

[Example 7]

A conductive coating material (synthetic resin paint (conductive) "Polycalm PCS-104n Ni (nickel powder-containing conductive paint)" produced by Plascoat Co., Ltd.) was spray-coated onto a magnetic layer (having a thickness of 85 $\mu$m after subjected to compression-molding) produced by the same method as used in Example 6, thereby obtaining a conductive layer having a thickness of 15 $\mu$m. The thus obtained conductive layer had a surface electrical resistance of 110 $\Omega/\square$, and the magnetic layer had a magnetic permeability of 25 as measured at 100 MHz. The resulting laminated sheet was subjected to measurement using a microstripline. As a result of the measurement, it was confirmed that a transmission loss S21 and a reflection coefficient of the sheet were 2.8 dB and -9.3 dB, respectively, as measured at 500 MHz, and 17 dB and -11.7 dB, respectively, as measured at 3 GHz, and therefore the sheet had an excellent low-pass filter characteristic.

[Example 8]

The same procedure as in Example 3 was conducted except that the conductive layer and the magnetic layer were produced without adding any flame retardant thereto, thereby obtaining a laminated sheet. Properties of the thus obtained laminated sheet are shown in Table 1.

[Comparative Example 1]

A single magnetic layer was produced in the same manner as in Example 1. Specifically, two kinds of flat metal particles each comprising iron, aluminum and silicon at a weight ratio of 85:6:9 and having an aspect ratio of 15 to 20 and a density of 6.9 which had average particle diameters of 50 $\mu$m and 75 $\mu$m, respectively, were mixed at a weight ratio of 2:1 to prepare magnetic particles, and the concentration of the slurry was controlled such that the volume of the magnetic particles in the magnetic layer obtained after removing a solvent therefrom by drying became 46% by volume, thereby obtaining a sheet having a thickness of 125 $\mu$m. When the resulting sheet was subjected to thermal compression-molding at 120°C under 60 MPa for 2 min, the thickness of the obtained sheet was 115 $\mu$m. Therefore, the sheet was subjected to thermal compression-molding at 130°C under 90 MPa for 5 min to obtain a sheet having a thickness of 100 $\mu$m. The thus obtained sheet had a poor flexibility. Also, the sheet had a magnetic permeability $\mu$' of 50 as measured at 100 MHz. Thus, it was confirmed that in order to obtain a single magnetic layer having a good low-pass filter characteristic in which the flat magnetic particles were filled with a high density, it was required to preliminarily mix different kinds of magnetic particles which were different in average particle diameter from each other, increase a molding temperature and a molding pressure, or prolong a pressing time, which results in complicated process and therefore is unsuitable for mass-production of the sheet.

The resulting single layer magnetic sheet was subjected to measurement using a microstripline. As a result of the measurement, it was confirmed that a transmission loss S21 and a reflection coefficient of the sheet were 3 dB and -7.9 dB, respectively, as measured at 500 MHz, and 14 dB and -9.8 dB, respectively, as measured at 3 GHz. Thus, the sheet had an increased reflection coefficient as measured at 500 MHz, and therefore exhibited a poor characteristic having problems such as attenuation in signal bands.

In Comparative Example 2, the same procedure as in Example 1 was conducted except that conductive metal particles (gold particles; "AUP500" produced by Osaki Industry Co., Ltd.; density: 19.3 g/cm$^3$) were used in an amount of 5% by volume, thereby obtaining a sheet. The conductive layer of the thus obtained sheet had a surface electrical resistance as high as 9000 $\Omega/\square$. The resulting laminated sheet was subjected to measurement using a microstripline. As a result of the measurement, it was confirmed that a transmission loss S21 of the sheet was 1 dB as measured at 500 MHz and 1.5 dB as measured at 3 GHz, and therefore the sheet had a poor low-pass filter characteristic because of a very low transmission loss as measured at 3 GHz.

In Comparative Examples 3 to 5, the same procedure as in Example 2 was conducted except that the magnetic particles shown in Table 2 and the formulation as shown in Table 1 were used, thereby obtaining sheets. Various properties of the resulting sheets are shown in Table 1.

The laminated sheets obtained in Comparative Examples 3 to 5 were subjected to measurement using a microstripline. As a result of the measurement, it was confirmed that these sheets were incapable of satisfying such a requirement for good low-pass filter characteristic that a transmission loss S21 thereof is not more than 3 dB as measured at 500 MHz and not less than 10 dB as measured at 3 GHz, and therefore the sheet exhibited a poor low-pass filter characteristic.

[Comparative Example 6]

The single conductive layer sheet was produced in the same manner as in Example 5. The resulting sheet had a thickness of 20 $\mu$m and a surface electrical resistance of 140 $\Omega/\square$. The resulting sheet was subjected to measurement for a transmission loss S21. As a result of the measurement, it was confirmed that a transmission S21 of the sheet was 3.7 dB as measured at 500 MHz and 13.5 dB as measured at 3 GHz. As a result, the transmission signal was reduced owing to a large transmission loss as measured at a low frequency of 500 MHz.

## Table 1

| Examples and Comparative Examples | Conductive layer | | | | |
|---|---|---|---|---|---|
| | Conductive metal particles | | | | Conductive coating material |
| | Gold | Silver | Copper | Nickel | Nickel coating material |
| Example 1 | 30 | | | | |
| Example 2 | | 20 | 13 | | |
| Example 3 | | | | 25 | |
| Example 4 | | | 5 | 25 | |
| Example 5 | | 10 | 25 | | |
| Example 6 | | | | 40 | |
| Example 7 | | | | | (A) |
| Example 8 | | | 5 | 25 | |
| Comparative Example 1 | | | | | |
| Comparative Example 2 | 5 | | | | |
| Comparative Example 3 | | | | 10 | |
| Comparative Example 4 | | | 50 | | |
| Comparative Example 5 | | 45 | | | |
| Comparative Example 6 | | 10 | 25 | | |

Note (A): nickel powder-containing conductive paint "Polycalm PCS-104" produced by Plascoat Co., Ltd.

Table 1 (continued)

| Examples and Comparative Examples | Conductive layer | | | | |
|---|---|---|---|---|---|
| | Flame retardant | | Total amount of fillers (vol%) | Surface electrical resistance ($\Omega/\square$) | Sheet thickness ($\mu$m) |
| | *1 | *2 | | | |
| Example 1 | 15 | 20 | 65 | 460 | 20 |
| Example 2 | 15 | 15 | 63 | 230 | 20 |
| Example 3 | 20 | 20 | 65 | 4600 | 20 |
| Example 4 | 16 | 15 | 61 | 600 | 20 |
| Example 5 | 20 | 20 | 75 | 140 | 20 |
| Example 6 | 10 | 20 | 70 | 108 | 25 |
| Example 7 | | | 0 | 110 | 15 |
| Example 8 | | | 30 | 600 | 20 |
| Comparative Example 1 | | | | | |
| Comparative Example 2 | 8 | 8 | 21 | 9000 | 20 |
| Comparative Example 3 | 8 | 8 | 26 | ≥10000 | 20 |
| Comparative Example 4 | | | 50 | 16 | 20 |
| Comparative Example 5 | 8 | 8 | 61 | 75 | 20 |
| Comparative Example 6 | 20 | 20 | 75 | 140 | 20 |

Note: *1: Melamine phosphate
*2: $Mg(OH)_2$

Table 1 (continued)

| Examples and Comparative Examples | Magnetic layer | | | | | |
|---|---|---|---|---|---|---|
| | Carbonyl iron | Ferrite | Flat Sendust | | Sheet thickness | Magnetic permeability |
| | R1470 | BSN714 | (A) | (B) | (µm) | at 100 MHz |
| Example 1 | | | 44 | | 70 | 43 |
| Example 2 | | | 40 | | 80 | 40 |
| Example 3 | 60 | | | | 80 | 7 |
| Example 4 | | | 38 | | 80 | 25 |
| Example 5 | | 60 | | | 80 | 4 |
| Example 6 | | | 38 | | 75 | 25 |
| Example 7 | | | 38 | | 85 | 25 |
| Example 8 | | | 38 | | 80 | 25 |
| Comparative Example 1 | | | | 46 | 100 | 50 |
| Comparative Example 2 | | | 44 | | 80 | 43 |
| Comparative Example 3 | 60 | | | | 80 | 7 |
| Comparative Example 4 | | | 44 | | 80 | 43 |
| Comparative Example 5 | | 60 | | | 80 | 4 |
| Comparative Example 6 | | | | | 0 | - |

Table 1 (continued)

| Examples and Comparative Examples | Laminated sheet | | | | |
|---|---|---|---|---|---|
| | Thickness (μm) | S21 (dB) | | S11 (dB) | |
| | | At 500 MHz | At 3 GHz | At 500 MHz | At 3 GHz |
| Example 1 | 90 | 2.4 | 13 | -10.5 | -14 |
| Example 2 | 100 | 2.2 | 18 | -9.8 | -12.5 |
| Example 3 | 100 | 1.7 | 10.5 | -12.5 | -16.5 |
| Example 4 | 100 | 2.5 | 11 | -11.2 | -14.5 |
| Example 5 | 100 | 2.7 | 13 | -9.9 | -12.8 |
| Example 6 | 100 | 2.9 | 18 | -9.2 | -11.3 |
| Example 7 | 100 | 2.8 | 17 | -9.3 | -11.1 |
| Example 8 | 100 | 2.5 | 11 | -11.2 | -14.5 |
| Comparative Example 1 | 100 | 3 | 14 | -7.8 | -9.8 |
| Comparative Example 2 | 100 | 1 | 1.5 | -18.2 | -20.2 |
| Comparative Example 3 | 100 | 1.5 | 8 | -18.5 | -20.6 |
| Comparative Example 4 | 100 | 7 | 17 | -5.5 | -7.6 |
| Comparative Example 5 | 100 | 3.9 | 12 | -7.8 | -8.9 |
| Comparative Example 6 | 20 | 3.7 | 13.5 | -6.8 | -9.5 |

Table 2

| | | Density |
|---|---|---|
| Conductive material | | |
| Metal particles | | |
| Nickel | "NF40" produced by Toho Titanium Co., Ltd. (particle diameter: 0.4 μm) | 7.8 |
| Gold | "AUP500" produced by Osaki Industry Co., Ltd. (particle diameter: 0.5 μm) | 19.3 |
| Silver | "AG2500SS" produced by Osaki Industry Co., Ltd. (particle diameter: 0.5 μm) | 10.5 |
| Copper | "CE-1110" produced by Fukuda Metal Foil & Powder Co., Ltd. (particle diameter: 12 μm) | 8.9 |
| Conductive coating material | "Polycalm PCS-104n Ni (nickel-based paint)" produced by Plascoat Co., Ltd. | |
| Ferrite | "BSN-714" produced by Toda Kogyo Corp. | 5.1 |
| Carbonyl iron powder | Produced by ISP Japan Co., Ltd. | |
| Flat metal particles SENDUST (A) | FeAlSi 85:6:9 D50: 50 μm | 6.9 |

(continued)

| | | Density |
|---|---|---|
| Conductive material | | |
| Metal particles | | |
| Flat metal particles SENDUST (B) | FeAlSi 85:6:9 D50: 75 $\mu$m:50 $\mu$m=1:2 (as mixed particles) | 6.9 |
| Flame retardant | Magnesium hydroxide "KISMA 5A" produced by Kyowa Chemical Co., Ltd. | 2.4 |
| | Melamine polyphosphate "MPP-A" produced by Sanwa Chemical Co., Ltd. | 1.8 |
| Resin 1 | Styrene-based elastomer "TF-4200E" produced by Hitachi Kasei Kogyo Co., Ltd. | 0.9 |
| Resin 2 | Phenol-based resin "115B" produced by Tomoegawa Co., Ltd. | 1.1 |

Meanwhile, in Table 1, the balance of a total amount (% by volume) of the above components is an amount of a resin.

INDUSTRIAL APPLICABILITY

The electromagnetic interference suppressor according to the present invention can exhibit excellent properties even when the sheet has a low magnetic permeability. Thus, the electromagnetic interference suppressor according to the present invention is excellent in low-pass filter characteristic in a near electromagnetic field and therefore suitable as an electromagnetic interference suppression sheet.

**Claims**

1. An electromagnetic interference suppressor comprising:

   a conductive layer which comprises a conductive filler comprising at least one metal selected from the group consisting of gold, silver, copper and nickel, and which has a surface electrical resistance of 100 to 5000 $\Omega/\square$; and a magnetic layer comprising soft magnetic particles and a resin which is laminated on the conductive layer.

2. The electromagnetic interference suppressor according to claim 1, wherein the conductive layer comprises the conductive filler comprising a resin and at least one metal selected from the group consisting of gold, silver, copper and nickel.

3. The electromagnetic interference suppressor according to claim 1, wherein a real part of a complex relative magnetic permeability of the magnetic layer as measured at 100 MHz is 3 to 45.

4. The electromagnetic interference suppressor according to claim 1, wherein a content of the conductive filler in the conductive layer is 15 to 40% by volume.

5. The electromagnetic interference suppressor according to claim 1, wherein the soft magnetic particles are formed of at least one material selected from the group consisting of carbonyl iron, magnetite, spinel ferrite and Sendust.

6. The electromagnetic interference suppressor according to claim 1, wherein the conductive layer has a thickness of 10 to 50 $\mu$m, and the magnetic layer has a thickness of 50 to 200 $\mu$m.

7. The electromagnetic interference suppressor according to claim 1, wherein when subjecting the electromagnetic interference suppressor having a thickness of not more than 100 $\mu$m to measurement using a microstripline, a transmission loss and a reflection coefficient thereof are not more than 3 dB and not more than -9 dB, respectively, as measured at 500 MHz, and not less than 10 dB and not more than -9 dB, respectively, as measured at 3 GHz.

**INTERNATIONAL SEARCH REPORT**

| International application No. |
|---|
| PCT/JP2013/083720 |

A. CLASSIFICATION OF SUBJECT MATTER
*H05K9/00(2006.01)i, H01F1/00(2006.01)i, H01F1/22(2006.01)i*

According to International Patent Classification (IPC) or to both national classification and IPC

B. FIELDS SEARCHED

Minimum documentation searched (classification system followed by classification symbols)
H05K9/00, H01F1/00, H01F1/22

Documentation searched other than minimum documentation to the extent that such documents are included in the fields searched
Jitsuyo Shinan Koho          1922–1996     Jitsuyo Shinan Toroku Koho    1996–2014
Kokai Jitsuyo Shinan Koho    1971–2014     Toroku Jitsuyo Shinan Koho    1994–2014

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| Y | JP 2010-153542 A (Kabushiki Kaisha Ado Union Kenkyusho), 08 July 2010 (08.07.2010), claims; paragraphs [0001] to [0059]; fig. 1 (Family: none) | 1-7 |
| Y | JP 2000-244171 A (Tokin Corp.), 08 September 2000 (08.09.2000), paragraphs [0007] to [0012] (Family: none) | 1-7 |
| Y | JP 2006-196747 A (Toda Kogyo Corp.), 27 July 2006 (27.07.2006), claims; paragraphs [0001], [0025], [0029] to [0031] (Family: none) | 3,7 |

☒ Further documents are listed in the continuation of Box C.          ☐ See patent family annex.

| | |
|---|---|
| * Special categories of cited documents: | "T" later document published after the international filing date or priority date and not in conflict with the application but cited to understand the principle or theory underlying the invention |
| "A" document defining the general state of the art which is not considered to be of particular relevance | |
| "E" earlier application or patent but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
|---|---|
| 31 January, 2014 (31.01.14) | 10 February, 2014 (10.02.14) |

| Name and mailing address of the ISA/ | Authorized officer |
|---|---|
| Japanese Patent Office | |
| Facsimile No. | Telephone No. |

Form PCT/ISA/210 (second sheet) (July 2009)

**INTERNATIONAL SEARCH REPORT**

International application No.

PCT/JP2013/083720

C (Continuation).   DOCUMENTS CONSIDERED TO BE RELEVANT

| Category* | Citation of document, with indication, where appropriate, of the relevant passages | Relevant to claim No. |
|---|---|---|
| A | JP 2008-244358 A  (Nippon Valqua Industries, Ltd.), 09 October 2008 (09.10.2008), claims; paragraphs [0001], [0015] to [0016], [0027] (Family: none) | 1-7 |
| A | JP 2012-151242 A  (TDK Corp.), 09 August 2012 (09.08.2012), entire text; all drawings (Family: none) | 1-7 |
| A | JP 2008-186997 A  (Toray Industries, Inc.), 14 August 2008 (14.08.2008), entire text; all drawings (Family: none) | 1-7 |
| A | JP 2008-140963 A  (Tomoegawa Paper Co., Ltd.), 19 June 2008 (19.06.2008), entire text; all drawings (Family: none) | 1-7 |
| A | JP 2003-283179 A  (Daido Steel Co., Ltd.), 03 October 2003 (03.10.2003), entire text; all drawings (Family: none) | 1-7 |

Form PCT/ISA/210 (continuation of second sheet) (July 2009)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 7212079 A
- JP 2000244171 A
- JP 10075088 A
- JP 2002198686 A
- JP 2010135701 A
- JP 2006196747 A
- JP 2007288006 A
- JP 2007129179 A
- JP 2008244358 A
- JP 2010153542 A

**Non-patent literature cited in the description**

- **OSAMU HASHIMOTO.** Trend of Wave Absorbers. *Journal of the Institute of Electronics, Information and Communication Engineers,* October 2003, vol. 86 (10), 800-803
- **NOBUYUKI HIRATSUKA.** *Soft Magnetic Materials for Noise Suppression and Applications thereof,* May 2008